Europäisches Patentamt

European Patent Office

Office européen des brevets

(19)

(11) **EP 1 465 261 A1**

(12) **EUROPEAN PATENT APPLICATION**
published in accordance with Art. 158(3) EPC

(43) Date of publication:
  **06.10.2004 Bulletin 2004/41**

(51) Int Cl.⁷: **H01L 31/042**

(21) Application number: **02724678.4**

(86) International application number:
  **PCT/JP2002/004392**

(22) Date of filing: **02.05.2002**

(87) International publication number:
  **WO 2002/091481 (14.11.2002 Gazette 2002/46)**

(84) Designated Contracting States:
  **AT BE CH DE ES GB LI**

(30) Priority: **02.05.2001 JP 2001135424**

(71) Applicant: **Japan Science and Technology Agency
  Kawaguchi-shi Saitama (JP)**

(72) Inventors:
  • **KUROKAWA, Kosuke
    Kodaira-shi, Tokyo 187-0001 (JP)**

  • **UNO, Toru
    Fuchu-shi, Tokyo 183-0054 (JP)**
  • **TAKAHASHI, Masaharu
    Yachiyo-shi, Chiba 276-0049 (JP)**

(74) Representative: **Röhl, Wolf Horst, Dipl.-Phys., Dr.
  Sparing-Röhl-Henseler
  Patentanwälte
  Postfach 14 04 43
  40074 Düsseldorf (DE)**

(54) **METHOD FOR ABSORBING ELECTROMAGNETIC WAVE USING SOLAR CELL**

(57)    An electromagnetic-wave absorbing method using a solar cell or cells is provided, whereby there comes about essentially no reflection of electromagnetic waves by the solar cell or cells without impeding solar light power generation thereby. A solar cell module (10) may be constructed from a plurality of solar cells (1) wherein respective upper electrodes (2, 2) are electrically connected together by a conductor (7) and a common lower electrode (6) is used. So that any possibly reflected wave may be absorbed, the impedance of the solar cells to electromagnetic waves incident thereon is matched to an electromagnetic-wave characteristic impedance by adjusting the number of the solar cells (1) arranged or the way in which they are arranged or by connecting a capacitor (13) across a pair of output terminals (8, 9) of the module. Alternatively, a plurality of such solar cell modules (10) different in shape and/or surface area are arranged in such a manner that reflected wave being reflected by the individual solar cell modules differ in phase so that they may be canceled one by another. Alternatively, it is possible to form an electromagnetic wave reflector (54, 57) on a rear surface of the solar cell (1) or on a wall surface over which it is to be mounted and a reticular electromagnetic-wave reflector (55) on a top surface of the solar cell, in an arrangement such that a reflected wave being reflected by the electromagnetic-wave reflector (54, 57) on the rear surface or the wall surface and a reflected wave being reflected by the reticular electromagnetic-wave reflector (55) may interfere with each other and be thereby cancelled each by other.

FIG. 1

**Description**

Technical Field

The present invention relates to electromagnetic-wave absorbing methods using a solar cell or cells and in particular to methods of absorbing electromagnetic waves with a solar cell or cells whereby there comes about essentially no reflection of electromagnetic waves without impeding solar light power generation by the solar cell or cells.

Background Art

As one of troubles associated with electromagnetic waves there is a so-called ghost phenomenon in which a TV image is doubled due to the fact that TV electromagnetic waves are reflected by a wall surface of a building such as a high-rise building or skyscraper.

To get rid of such a ghost phenomenon, a measure can be taken in the reception side but basically it is important that the wall surfaces of such a high building be adapted not to reflect electromagnetic waves. Especially these days that the city is flooded with electromagnetic waves from cellular phones or the like, an unforeseen accident can be predicted and a technique of preventing electromagnetic waves from being reflected is being sought.

In order to absorb TV electromagnetic waves in the VHF band, the use of a ferrite-type electromagnetic-wave absorbing wall having a ferrite tile embedded in a curtain wall has so far been proposed for a building wall surface. However, not only is the ferrite-type electromagnetic-wave absorbing wall inapplicable to absorbing electromagnetic waves in the UHF band, but also it is heavy in weight, and rather hard to construct practically and economically. For these reasons, the ferrite-type electromagnetic-wave absorber wall has scarcely come into wide use in general buildings.

On the other hand, the utilization of solar energy in order to preserve the global environments intact makes progress to an extent that a solar cell panel is being laid on a general building wall. A solar cell made of Si (silicon), however, has entailed the problem that a solar cell acts as a reflector to electromagnetic waves and brings about an unanticipated ghost trouble, and hence the solar panel has not yet come into general use as expected.

Disclosure of the Invention

In view of the aforementioned problems in the prior art, the present invention has for its object to provide an electromagnetic wave absorbing method using a solar cell or cells, which can prevent the reflection of electromagnetic waves without impeding solar light power generation by the solar cell or cells.

In order to achieve the object mentioned above, there is provided in accordance with the present invention a method of absorbing electromagnetic waves with a solar cell or cells, characterized by adjusting impedance of a solar cell to electromagnetic waves incident thereon so that there is virtually no reflection of the electromagnetic wave by the solar cell.

In the method mentioned above, the impedance can be adjusted specifically by changing or adjusting the way in which the solar cells are wired together.

In the method mentioned above, the impedance can also be adjusted specifically by appending a capacitor across output terminals of a solar cell module.

In the method mentioned above, the impedance can also be adjusted specifically by appending an electronic component or components to the solar cell or cells internally or externally thereof.

According to these electromagnetic-wave absorbing methods using a solar cell or cells, the impedance of the solar cell or cells is matched to an electromagnetic-wave characteristic impedance; hence there comes about virtually no reflection of an electric wave by the solar cell or solar cells.

Since the energy of electromagnetic waves in the UHF and VHF ranges is lower than the absorption limit energy of a solar cell, a protective film and semiconductor layers making up a solar cell act as dielectrics for electromagnetic waves in the UHF and VHF ranges while a wiring conductor being metallic in the solar cell acts as a reflector. Changing the distribution of wiring conductors in solar cells changes the boundary condition for electromagnetic waves and changes the capacitance and inductance; hence that can be used to adjust the impedance of a solar cell to electromagnetic waves incident thereon. In order to change the distribution of wiring conductors in a solar cell module, the solar cells making up the module can be adjusted in their arrangement and then wired together. The impedance can also be adjusted by appending a capacitor across a pair of output terminals of the solar cell module, or by appending an electronic component such as a capacitor to a solar cell internally or externally thereof.

These specific methods, none of which produces any short circuit condition for a direct current, exert no adverse influence on solar light power generation by the solar cell or cells while preventing electromagnetic waves from reflecting.

There is also provided in accordance with the present invention a method of absorbing electromagnetic waves with a solar cell or cells, characterized by arranging a plurality of solar cell modules different in shape and/or surface area in such a manner that reflected waves from the individual solar cell modules vary in phase so that they are canceled one by another.

According to this method which is designed to adjust the phases of reflected waves of incident electromagnetic waves advantageously in terms of the shape and/or surface areas of modules, the modules can be so arranged that the reflected waves may be formed which are opposite in phase to one another and can thus be cancelled one by another.

In the method mentioned above, a plurality of solar cells can be connected together in the form of an antenna such as to absorb electromagnetic waves.

Alternatively, a plurality of solar cells may be connected together in the form of a loop and a matching load may then be connected across loop ends of the loop.

Alternatively, upper and lower electrodes of a plurality of solar cells may be connected respectively in series, and a matching load may then be connected across a pair of output terminals leading from such an upper and a lower electrode.

According to the specific methods mentioned above, the solar cells are allowed to act as a loop antenna or a patch antenna and the matching load to act to absorb the electromagnetic energy; hence virtually no reflected wave is produced.

The present invention also provides a method of absorbing electromagnetic waves with a solar cell or cells, characterized by adjusting respective thicknesses of various layers of a solar cell so that reflected waves reflected, respectively, by these layers interfere with one another and are thereby cancelled one by another.

The present invention also provides a method of absorbing electromagnetic waves with a solar cell or cells, characterized by forming an solar cell with an electromagnetic-wave reflector on a rear surface thereof and with a reticular electromagnetic-wave reflector on a top surface thereof in an arrangement such that a reflected wave being reflected by the electromagnetic-wave reflector on the rear surface and a reflected wave being reflected by the reticular electromagnetic-wave reflector may interfere with each other and be thereby cancelled each by other.

The present invention also provides a method of absorbing electromagnetic waves with a solar cell, characterized by forming an electromagnetic-wave reflector on a wall surface over which a solar cell is to be mounted and forming a reticular electromagnetic-wave reflector on a top surface of the solar cell, in an arrangement such that a reflected wave being reflected by the electromagnetic-wave reflector on the wall surface and a reflected wave being reflected by the reticular electromagnetic-wave reflector may interfere with each other and be thereby cancelled each by other.

According to these methods, virtually no reflected wave is produced from electromagnetic waves incident on a solar cell on the one hand and power generation from solar light is possible on the other hand.

Brief Description of the Drawings

The present invention will better be understood from the following detailed description and the drawings attached hereto showing certain illustrative forms of implementation of the present invention. In this connection, it should be noted that such forms of implementation illustrated in the accompanying drawings hereof are intended in no way to limit the present invention but to facilitate an explanation and understanding thereof. In the drawings:

Fig. 1 is a typical cross sectional view illustrating a first form of implementation of the present invention;
Fig. 2 is a diagram illustrating a second form of implementation of the present invention;
Fig. 3 is a diagram of the vector representation of phase angles of reflected waves from a plurality of modules which differ in phase angle of reflection coefficient;
Fig. 4 shows diagrams illustrating a third form of implementation of the present invention;
Fig. 5 shows views illustrating a fourth form of implementation of the present invention; and
Fig. 6 includes a view, a table, and a graph, illustrating a specific example according to the fourth form of implementation of the present invention.

Best Modes for Carrying Out the Invention

Hereinafter, the present invention will be described in detail with reference to suitable forms of implementation thereof illustrated in the drawing figures.

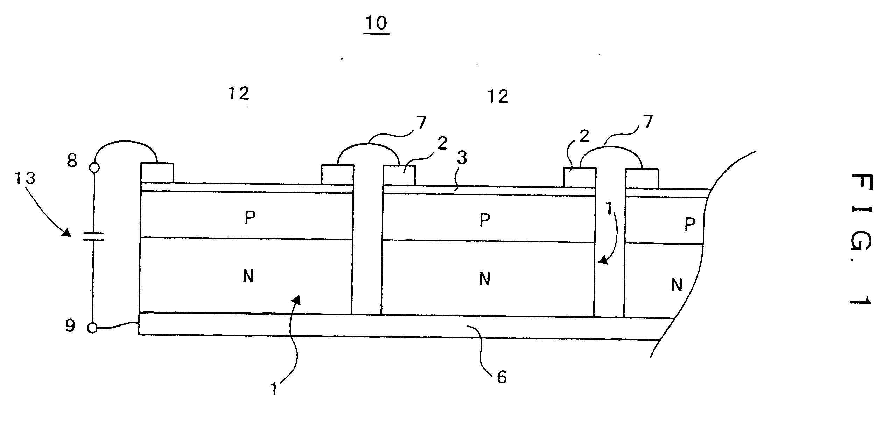

At the outset, mention is made of a first form of implementation of the present invention. Fig. 1 is a typical cross sectional view illustrating a first form of implementation of the present invention. A solar cell module 10 according to the present invention is made up of a plurality of solar cells 1 connected one to another by conductors 7 wherein each solar cell 1 comprises an upper electrode 2, a transparent electrode 3, a semiconductor p-layer 4, a semiconductor n-layer 5 and a lower electrode 6. In the example illustrated in the Figure, the solar cells 1 are connected parallel to each other with the upper electrodes 2 in the adjacent cells 1 connected together and the lower electrode 6 used in common, and further with a capacitor 13 connected across output terminals 8 and 9 of the solar cell module, although the capacitor 13 may be omitted and the solar cells 1 may be connected in series or connected both in series and parallel in any of various possible combinations.

By the way, when electromagnetic waves 12 are incident on a solar cell 1, if the impedance of the solar cell 1 when seen from the electromagnetic waves 12 incident on the solar cell 1 is expressed by Z, then its reflectivity τ for the solar cell is given by equation (1) as follows:

$$\tau = \frac{Z - Z_O}{Z + Z_O} \tag{1}$$

Changing the way in which the solar cells 1 that make up the solar cell module 10 as shown in Fig. 1 are wired together, changes the boundary condition for the electromagnetic waves, and therefore changes their conductance and inductance. Hence the impedance Z of the solar cells 1 seen from the electromagnetic waves 12 incident thereon can be adjusted by so changing or adjusting. Also, the impedance Z can be adjusted, e. g., by changing or adjusting the number of series- and/or parallel-connected solar cells. Further, the impedance can be adjusted by changing or adjusting the way in which a module or modules made of series-connected cells and a module or modules made of parallel-connected cells are combined together. Still further, the impedance Z can be adjusted more finely by changing or adjusting the way in which they are so combined when series-connected cells and parallel-connected cells are different in number. Yet further, the impedance Z can be adjusted by connecting a capacitor 13 across output terminals 8 and 9 of the module. Of course, such an electronic component as a capacitor may be attached to each of all or selected ones of the solar cells 1 externally or internally thereof. The capacitor passes no direct current and hence exerts no influence on solar light power generation. If in any of these ways the impedance Z of the solar cell or cells is so adjusted that the same becomes equal to electromagnetic-wave characteristic impedance $Z_0$, then the reflection coefficient τ becomes zero and virtually no reflection of the electromagnetic wave comes about.

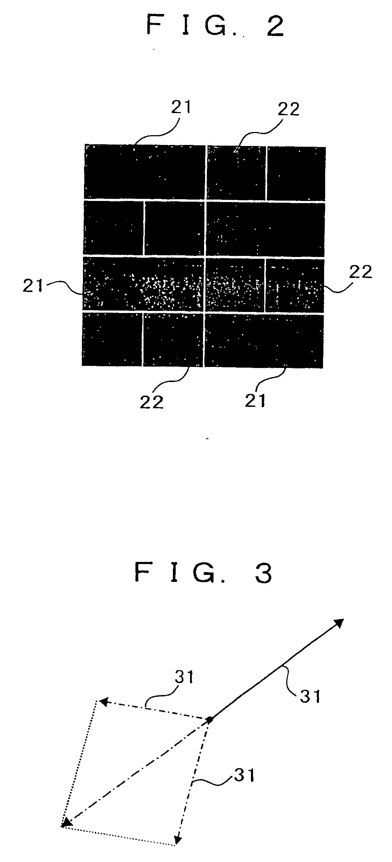

Mention is next made of a second form of implementation of the present invention. Fig. 2 is a diagram illustrating a second form of implementation of the present invention. In the Figure, reference numerals 21 and 22 indicate solar cell modules different in surface area, which are shown as arranged lying on a wall surface. Here, if the impedance of a solar cell module 21 and the impedance of a solar module 22 are expressed by $Z_A$ and $Z_B$, respectively, their respective reflection coefficients $\tau_A$ and $\tau_B$ are given by the following equations, respectively:

$$\tau_A = \frac{Z_A - Z_O}{Z_A + Z_O} \tag{2}$$

$$\tau_B = \frac{Z_B - Z_O}{Z_B + Z_O} \tag{3}$$

In high-frequency ranges such as UHF and VHF bands, since media making up a solar cell provides an impedance that is expressed by a complex number, the impedances $Z_A$ and $Z_B$ can be expressed by equations (4) and (5) as follows:

$$Z_A = Z_a + jZ_{aa} \tag{4}$$

$$Z_B = Z_b + jZ_{bb} \tag{5}$$

where Za and Zb indicate each a real part, and Zaa and Zbb indicate each an imaginary part. Therefore, the reflection coefficients $\tau_A$ and $\tau_B$ are given by equations (6) and (7) as follows:

$$\tau_A = \frac{1}{(Z_a+Z_O)^2+Z_{aa}}\left\{(Z_a^2+Z_{aa}^2-Z_O^2)+j2Z_{aa}\right\} \qquad (6)$$

$$\tau_B = \frac{1}{(Z_b+Z_O)^2+Z_{bb}}\left\{(Z_b^2+Z_{bb}^2-Z_O^2)+j2Z_{bb}\right\} \qquad (7)$$

Further, with their real parts and imaginary parts expressed as $\tau_{ZA}$ and $\tau_{ZB}$; and $\tau j_{ZA}$ and $\tau j_{ZB}$, respectively, the reflection coefficients $\tau_A$ and $\tau_B$ are given by equations (8) and (9) as follows:

$$\tau_A = \tau_{ZA} + j\tau_{jZA} \qquad (8)$$

$$\tau_B = \tau_{ZB} + j\tau_{jBA} \qquad (9)$$

Hence, the respective phase angles $\theta_A$ and $\theta_B$ of reflected waves from a solar cell module 21 and a solar cell module 22 are given by equations (10) and (11) as follows:

$$\theta_A = \tan^{-1}\frac{\tau_{jZA}}{\tau_{ZA}} \qquad (10)$$

$$\theta_B = \tan^{-1}\frac{\tau_{jZB}}{\tau_{ZB}} \qquad (11)$$

It follows, therefore, that if the impedances $Z_a$, $Z_b$, $Z_{aa}$, and $Z_{bb}$ of the modules 21 and 22 are adjusted so that the difference between the phase angles $\theta_A$ and $\theta_B$ of the reflected waves from the solar cell modules 21 and 22 becomes $\pi$, then the reflected waves from the solar modules 21 and 22 are opposite in phase to cancel each other, and essentially no reflected wave is emitted.

The impedances $Z_a$, $Z_b$, $Z_{aa}$, and $Z_{bb}$ can be adjusted by changing or adjusting the areas of solar cell modules, the manner in which they are wired, and the way in which they are arranged, or upon additionally connecting an electronic component such as a capacitor to the modules internally or externally thereof.

Fig. 3 is a diagram of the vector representation of phase angles of reflected waves from a plurality of modules which differ in phase angle in reflection coefficient. As shown, if a variety of phase angles 31 exist, then there come to be made pairs of reflected waves which cancel each other and, as a result, virtually any reflected wave is no longer emitted.

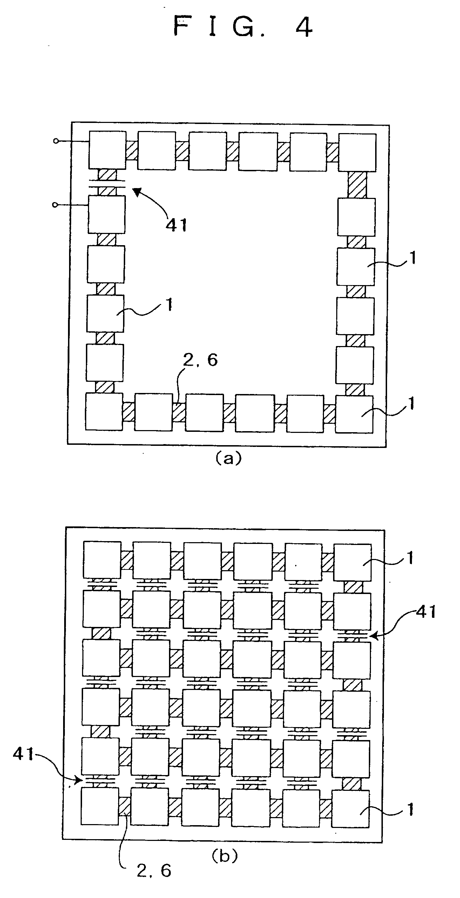

Mention is next made of a third form of implementation of the present invention. Fig. 4 shows diagrams illustrating a third form of implementation of the present invention. In Fig. 4, there are shown at (a) a plurality of solar cells 1 arranged in the form of a loop with their upper or lower electrodes connected in series and with a matching load 41 such as, for example, a capacitor connected across their loop ends.

According to this arrangement, the solar cells act as a loop antenna and the electromagnetic energy is absorbed in the matching load 41; hence virtually no reflected wave is emitted.

Fig. 4 also shows at (b) a plurality of solar cells 1 arranged in a zigzag form with both their upper and lower electrodes are connected in series, respectively.

According to this arrangement, wherein the solar cells act as a patch antenna and have matching loads 41 connected thereto as shown to absorb the electromagnetic energy, virtually no reflected light is emitted.

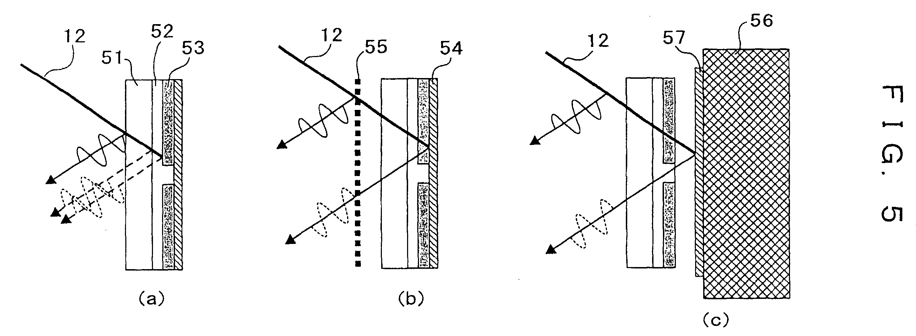

Mention is next made of a fourth form of implementation of the present invention. Fig. 5 has views illustrating a fourth form of implementation of the present invention.

Fig. 5 shows at (a) an embodiment in which the three medium layers of a solar cell, viz., a top glass layer 51, an EVA (ethylene-vinyl acetate) layer 52 and a semiconductor layer 53, have their respective thicknesses controlled or adjusted so that reflected waves reflected on their respective surfaces are opposite in phase. According to this arrangement, wherein reflected waves reflected on their respective surfaces are made opposite in phase, the reflected waves are canceled each by other.

Fig. 5 shows at (b) another embodiment in which a solar cell is coated on its rear surface with an electromagnetic-wave reflecting metallic film 54 and formed over its front surface with a reticular, electromagnetic-wave reflecting metallic film 55. Here, the spacing between the electromagnetic-wave reflecting metallic film 54 on the rear surface and the reticular, electromagnetic-wave reflecting film 55 is adjusted to cause a reflected wave reflected by the electromagnetic-wave reflecting film 54 on the rear surface and a reflected wave reflected by the reticular, electromagnetic-wave reflecting film 55 to interfere with each other, thereby canceling them each other. According to this embodiment, not only is emitted essentially no reflected wave, but also the incident solar light transmitting through the reticular, electromagnetic-wave reflecting film 55 can be used to generate electric power.

Fig: 5 shows at (c) a further embodiment in which a wall surface 56 over which a solar cell is to be disposed is provided with a reflector 57 for electromagnetic waves. In this embodiment, the spacing between the reflector 57 and the rear surface of the solar cell is adjusted so that the reflected wave from the reflector 57 and the reflected wave from the solar cell surface are opposite in phase to each other. According to this embodiment, these reflected waves cancel each other, and virtually no reflected wave is thus emitted.

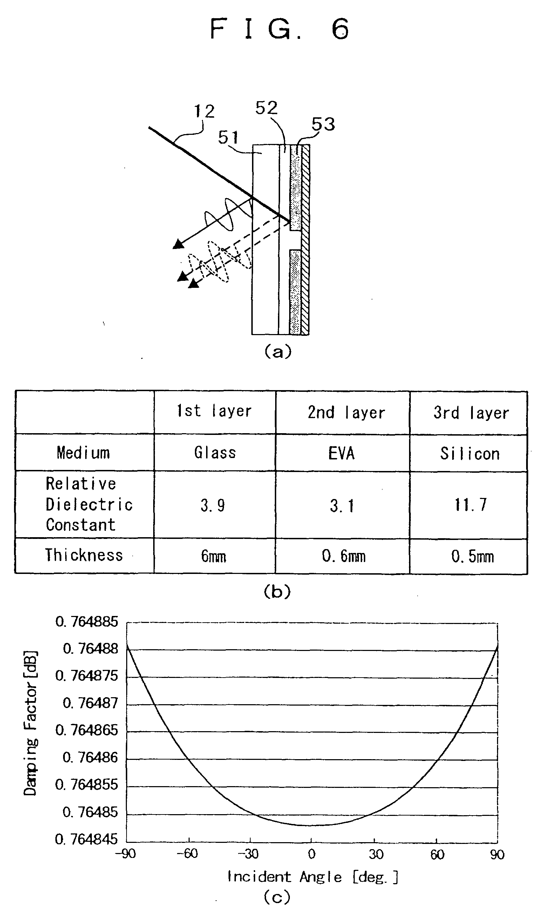

Mention is next made of a specific example of the present invention. Fig. 6 includes a view, a table, and a graph, illustrating a specific example according to the fourth form of implementation of the present invention. In the graph, the abscissa axis represents the angle at which electromagnetic waves is incident on a solar cell and the ordinate axis represents the damping factor measured when the three medium layers of the solar cell, namely the top glass layer 51, the EVA (ethylene-vinyl-acetate) layer 52 and the semiconductor layer 53 are adjusted in thickness so that the effect of canceling the reflected waves each other is maximized for the frequencies in the UHF band.

Industrial Applicability

As will be appreciated from the foregoing description, an electromagnetic-wave absorbing method using a solar cell in accordance with the present invention makes it possible to absorb electromagnetic waves without reflection thereof and without impeding solar light power generation. Consequently, applying an electromagnetic-wave absorbing method using a solar cell in accordance with the present invention to an existing solar cell system allows the solar cell system to generate power while preventing electromagnetic-wave troubles such as ghost images from coming about, thereby expediting the dissemination of solar cells and the preservation of global environments.

**Claims**

1. A method of absorbing electromagnetic waves with a solar cell or cells, **characterized by** adjusting impedance of a solar cell to electromagnetic waves incident thereon so that there comes about virtually no reflection of the electromagnetic waves by the solar cell.

2. A method of absorbing electromagnetic waves with a solar cell or cells as set forth in claim 1, **characterized in that** the impedance is adjusted by changing the way in which the solar cells are wired together.

3. A method of absorbing electromagnetic waves with a solar cell or cells as set forth in claim 1, **characterized in that** the impedance is adjusted by appending a capacitor across output terminals of a solar cell module.

4. A method of absorbing electromagnetic waves with a solar cell or cells as set forth in claim 1, **characterized in that** the impedance is adjusted by appending an electronic component or components to the solar cell or cells internally or externally thereof.

5. A method of absorbing electromagnetic waves with a solar cell or cells, **characterized by** arranging a plurality of solar cell modules different in shape and/or surface area in such a manner that reflected waves from the individual solar cell modules vary in phase so that they are canceled one by another.

6. A method of absorbing electromagnetic waves with a solar cell or cells, **characterized by** connecting a plurality of solar cells together in the form of an antenna such as to absorb electromagnetic waves.

7. A method of absorbing electromagnetic waves with a solar cell or cells as set forth in claim 6, **characterized by** connecting a plurality of solar cells together in the form of a loop and connecting a matching load across loop ends of the loop.

8. A method of absorbing electromagnetic waves with a solar cell or cells as set forth in claim 6, **characterized by** providing a plurality of solar cells having upper and lower electrodes which are connected in series, respectively, and connecting a matching load across a pair of output terminals leading from such an upper and a lower electrode, respectively.

9. A method of absorbing electromagnetic waves with a solar cell or cells, **characterized by** adjusting respective thicknesses of various layers of a solar cell so that reflected waves reflected, respectively, by these layers interfere with one another and are thereby cancelled one by another.

10. A method of absorbing electromagnetic waves with a solar cell or cells, **characterized by** forming an solar cell with an electromagnetic-wave reflector on a rear surface thereof and with a reticular electromagnetic-wave reflector on a top surface thereof in an arrangement such that a reflected wave being reflected by the electromagnetic-wave reflector on the rear surface and a reflected wave being reflected by the reticular electromagnetic-wave reflector may interfere with each other and be thereby cancelled each by other.

11. A method of absorbing electromagnetic waves with a solar cell, **characterized by** forming an electromagnetic reflector on a wall surface over which a solar cell is to be mounted and forming a reticular electromagnetic-wave reflector on a top surface of the solar cell, in an arrangement such that a reflected wave being reflected by the electromagnetic-wave reflector on the wall surface and a reflected wave being reflected by the reticular electromagnetic-wave reflector may interfere with each other and be thereby cancelled each by other.

FIG. 1

# F I G. 2

# F I G. 3

# F I G . 4

(a)

(b)

# F I G.  5

# F I G. 6

(a)

| | 1st layer | 2nd layer | 3rd layer |
|---|---|---|---|
| Medium | Glass | EVA | Silicon |
| Relative Dielectric Constant | 3.9 | 3.1 | 11.7 |
| Thickness | 6mm | 0.6mm | 0.5mm |

(b)

(c)

## INTERNATIONAL SEARCH REPORT

| | International application No. |
|---|---|
| | PCT/JP02/04392 |

**A. CLASSIFICATION OF SUBJECT MATTER**
Int.Cl⁷ H01L31/042

According to International Patent Classification (IPC) or to both national classification and IPC

**B. FIELDS SEARCHED**

Minimum documentation searched (classification system followed by classification symbols)
Int.Cl⁷ H01L31/04-31/078, H05K9/00, H01Q17/00

Documentation searched other than minimum documentation to the extent that such documents are included in the fields searched

| | | | |
|---|---|---|---|
| Jitsuyo Shinan Koho | 1940-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2001-119226 A (Institut für Solare Energieversorgungstechnik (ISET)),<br>27 April, 2001 (27.04.01),<br>Full text; Figs. 1 to 19<br>& DE 19938199 C      & EP 1076407 A | 6<br>7,8 |
| A | JP 02-143469 A (NGK Insulators, Ltd.),<br>01 June, 1990 (01.06.90),<br>Full text; Figs. 1 to 4<br>(Family: none) | 1-11 |
| A | JP 08-253913 A (Fujita Corp.),<br>01 October, 1996 (01.10.96),<br>Full text; Figs. 1 to 5<br>(Family: none) | 1-11 |

☒ Further documents are listed in the continuation of Box C.    ☐ See patent family annex.

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 30 May, 2002 (30.05.02) | 11 June, 2002 (11.06.02) |

| Name and mailing address of the ISA/<br>    Japanese Patent Office | Authorized officer |
|---|---|
| Facsimile No. | Telephone No. |

Form PCT/ISA/210 (second sheet) (July 1998)

## INTERNATIONAL SEARCH REPORT

| International application No. |
|---|
| PCT/JP02/04392 |

**C (Continuation). DOCUMENTS CONSIDERED TO BE RELEVANT**

| Category* | Citation of document, with indication, where appropriate, of the relevant passages | Relevant to claim No. |
|---|---|---|
| A | JP 11-150393 A (Oji Tobi Kabushiki Kaisha),<br>02 June, 1999 (02.06.99),<br>Full text; Figs. 1 to 10<br>(Family: none) | 1-5 |
| A | Microfilm of the specification and drawings annexed to the request of Japanese Utility Model Application No. 92963/1985(Laid-open No. 4198/1987)<br>(The Yokohama Rubber Co., Ltd.),<br>12 January, 1987 (12.01.87),<br>Full text; Figs. 1 to 4<br>(Family: none) | 5,9-11 |
| A | JP 06-237091 A (Hitachi Engineering Co., Ltd.),<br>23 August, 1994 (23.08.94),<br>Full text; Figs. 1 to 8<br>(Family: none) | 5,9-11 |
| A | JP 2000-049487 A (Hitachi, Ltd.),<br>18 February, 2000 (18.02.00),<br>Claims; Par. Nos. [0021] to [0023]; Fig. 2<br>(Family: none) | 6-8 |

Form PCT/ISA/210 (continuation of second sheet) (July 1998)